# FASCICULE DE BREVET EUROPEEN

(11) **EP 2 615 893 B1**
(45) Date de publication et mention de la délivrance du brevet: **25.02.2015**
(21) Numéro de dépôt: 12350004.3
(22) Date de dépôt: 20.12.2012
(51) Int. Cl.: H05K 5/06

(54) **Boitier assemblé étanche contenant une électronique**
Wasserdichtes Gehäuse, das eine elektronische Einheit enthält
Sealed assembled housing containing electronics

(30) Priorité: 12.01.2012 FR 1200092
(43) Date de publication de la demande: 17.07.2013
(73) Titulaire: Hydrelis, 62360 Isques (FR)
(72) Inventeur: Sartorius, Thierry, 62152 Hardelot (FR)
(74) Mandataire: Tournel, Jean Louis

(56) Documents cités:
- EP-A2- 2 184 962
- US-A1- 2011 044 018

## Description

L'invention se rapporte à un dispositif de protection étanche d'une électronique logée dans un boitier.

Les appareils électroniques sont sensibles à l'environnement et au minimum les composants doivent être protégés de tous contacts.

Les cartes électroniques sont placées dans des boitiers qui protègent l'électronique de contact accidentel pouvant détruire les circuits. Ces boitiers ont également vocation à limiter l'accès aux composants.

Un boitier est souvent constitué de deux coques complémentaires qui s'assemblent selon un plan de joint souvent par emboitement en sorte de créer une enveloppe protectrice entourant l'électronique.

Ces coques protègent donc mécaniquement l'électronique de chocs.

Outre le besoin de protection mécanique, une protection contre l'introduction de poussières ou d'eau est souvent requise.

Il existe une classification qui indique les conditions dans lequel le boitier peut travailler en présence ou non d'eau.

La zone de jonction des coques complémentaires est une zone sensible où l'eau peut pénétrer et c'est donc à ce niveau que des moyens d'étanchéités sont prévus.

Partout où il y a une solution de continuité, l'eau peut pénétrer dans le boitier.

Il est donc connu d'équiper la zone de jonction d'un joint d'étanchéité.

Le choix du joint dépend de la manière dont les coques s'assemblent et des conditions d'utilisation du boitier.

Pour chaque boitier, il faut donc concevoir un joint particulier.

On comprend qu'un boitier plongé dans l'eau une fraction de seconde ne nécessite pas une protection comparable à un boitier qui serait plongé dans l'eau une journée à 50 mètres de profondeur. Les joints doivent donc répondre aux conditions d'utilisation du boitier.

Les joints sont plus ou moins complexes et apportent des solutions toutefois, dans le temps le matériau composant ce joint se modifie avec le temps ( réaction induites par les rayons du soleil) et souvent ils durcissent et deviennent moins performant.

Outre cette zone de jonction, l'électronique du boitier est souvent, par une liaison filaire couplée, par exemple à un capteur ou à un autre dispositif. Le boitier présente alors une découpe au travers de laquelle passe la liaison filaire. Il existe des dispositifs appelés passe câbles qui confèrent une étanchéité. L'obtention d'une bonne étanchéité est encore plus difficile avec ces passes câbles.

Dans le domaine de la distribution électrique, il est connu d'enterrer les câbles et d'utiliser des boitiers pour loger un connecteur raccordant deux câbles disposés bout à bout.

Ce connecteur électrique de câbles est placé dans une enveloppe dans laquelle il est prévu une fenêtre utilisée ,après raccordement des câbles et assemblage des coques, pour introduire une résine à l'état liquide qui va remplir le boitier et ainsi noyer les contacts. Cette résine, en durcissant va empêcher l'eau d'atteindre les contacts électriques.

Sur ces raccords électriques, il n'y a quasiment pas de panne car il s'agit d'une pièce métallique sur laquelle on fixe les extrémités des dits câbles par contre sur un circuit électronique, un composant peut mal fonctionner et dans le cas où la résine enroberait le circuit celui-ci ne serait plus réparable.

Il est également connu EP-A-2 184 962 ou US2011/0044018 de remplir partiellement le boitier avec de la résine.

L'invention propose une solution intéressante.

A cet effet, l'invention a pour objet un dispositif comprenant un boitier 1 logeant une électronique obtenu par assemblage de deux coques (2,3) supérieure et inférieure par emboitement en référence à un plan dit de joint (J) horizontal correspondant au plan passant par le bord inférieur de la coque supérieure (2) avec :
- l'une (2) des coques dit coque supérieure ayant des dimensions aptes à loger toute l'électronique que doit contenir le boitier ceci dans un espace dit de sécurité situé à distance du plan de joint J prédéfini,
- l'autre coque dite inférieure ayant des dimensions aptes à loger la base de la coque supérieure plongeant dans de la résine, le niveau de la résine se situant au dessus du plan de joint mais sans atteindre le volume de sécurité (7), ce dispositif étant caractérisé en ce qu'il comprend des moyens (11) pour maintenir le bord inférieur de la coque supérieure à distance du fond de la coque inférieure en sorte de noyer la base de la coque supérieure au niveau des deux faces et du champ inférieur, les dits moyens comprenant une jupe (11A) extérieure à la coque supérieure dont le bord libre (11B) forme une butée venant en appui sur le bord libre (3A) de la paroi latérale de la coque inférieure pour en limiter l'emboitement.

L'invention sera bien comprise à l'aide de la description ci après faite à titre d'exemple non limitatif en regard du dessin qui représente :

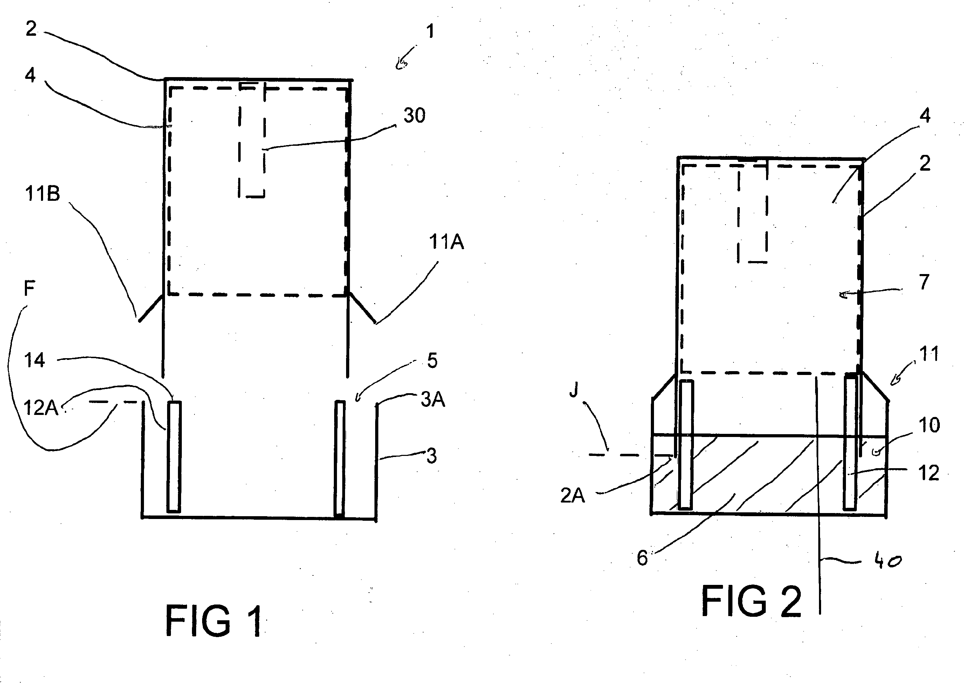

Fig 1 : une coupe axiale du boitier avant assemblage
FIg 2 : une coupe axiale du boitier après assemblage.

En se reportant au dessin, on voit un boitier constitué de deux coques 2,3 assemblées selon un plan de joint J.

Le plan de joint pris en référence est celui passant par le bord inférieur de la coque supérieure.

L'une des coques dit coque supérieure a des dimensions aptes à loger toute l'électronique que doit contenir le boitier ceci dans un espace ou volume dit de sécurité situé à distance du plan de joint défini par le plan contenant le bord inférieur de la coque supérieure. Ainsi entre le plan de joint et l'espace de sécurité est prévu un espace dit de remplissage qui occupe la section de la coque sur une épaisseur donnée.

La coque 2 supérieure présente une ouverture à sa base. Cette coque comprend une paroi supérieure et une paroi latérale. Le bord inférieur de la paroi latérale est dans le plan de joint. Cette coque a ici la forme d'un verre retournée.

L'autre coque dite inférieure comprend un fond et une paroi latérale et une ouverture supérieure. Elle a la forme d'un verre.

Cette coque 3 inférieure est dimensionnée en sorte de loger la base de la coque supérieure .

Le bord de la paroi latérale de la dite coque inférieure est plus haut que le niveau correspondant au plan de joint après emboitement.

Pour obtenir une étanchéité, on introduit dans la coque inférieure un volume de résine liquide, on emboite la coque supérieure dans la coque inférieure et on attend la prise de la résine.

On détermine la longueur d'emboitement en sorte que la base 2A de la coque supérieure se positionne à distance de la face interne du fond de la coque inférieure et on dimensionne la section de la coque inférieure pour ménager un espace autour de la base de la coque supérieure qui sera partiellement rempli par la résine. Pour cela des butés 11 limitent l'emboitement et des moyens 12 de positionnement axial centrent les coques.

La résine est donc en contact avec les faces interne et externe de la base de la coque supérieure ainsi que le champs inférieur et assure donc un recouvrement pour l'étanchéité.

On a donc constitué un plan de joint fictif enrobé dans de la résine.

Si l'eau tente de s'infiltrer, elle ne peut le faire qu'en se glissant entre la résine et la face externe de la base de la coque supérieure puis remonter entre la face interne de cette coque supérieure et la résine soit un parcours en chicane.

On aura prévu une excellente cohésion entre la résine et le matériau utilisé pour la coque.

Cela a deux conséquences : il y a création d'une étanchéité et création d'une liaison indémontable. Cependant, l'électronique n'est pas noyée dans la résine et en cas de panne peut être récupérée en coupant le boitier au dessus de la zone remplie de résine.

Si une liaison filaire 40 est prévue entre l'électronique et un dispositif nécessitant un trou au travers de la coque, le trou est localisé dans la paroi inférieure de la coque inférieure dans l'espace qui sera noyé dans la résine . Il est prévu cependant un passe cable.

La partie du passe câble située à l'intérieur de la coque sera noyée dans la résine.

La résine qui est introduite sous forme liquide va se durcir par réaction avec un moyen approprié tel un catalyseur. Cette résine pourra être protégée des UV et donc a une longévité accrue.

Pour positionner la carte sur laquelle sont montés les composants électroniques, il est ici prévu des glissières aménagées dans la paroi latérale de la coque supérieure sur sa face interne. La carte du circuit pourra être glissée dans deux glissières et ensuite être verrouillée.

Pour cela, par exemple, le fond de la coque inférieure présente au moins une patte 12A avec une butée 14 par exemple le fond d'une encoche tournée vers le haut qui vient s'engager sur la carte portant l'électronique lors de l'assemblage.

Avantageusement, les pattes sont au moins au nombre de deux et viennent localement en appui sur la face interne de la coque supérieure pour la maintenir centrée et sans contact avec la paroi latérale de la coque inférieure afin de dégager du volume pour la résine.

Pour limiter l'engagement de la coque supérieure, celle-ci présente extérieurement une jupe 11 A dont le bord libre 11B forme butée venant en appui sur le bord libre 3A de la paroi latérale de la coque inférieure.

Ainsi , on a décrit un procédé et des moyens pour obtenir l'étanchéité à l'eau d'un boitier 1 constitué de deux coques supérieure 2 et inférieure 3 assemblées selon un plan de joint J horizontal ce procédé étant caractérisé en ce que dans le boitier

On définit les dimensions de la coque supérieure pour loger toute l'électronique 4 dans un volume de sécurité situé au dessus du plan de joint,

On définit la coque inférieure telle que le plan F passant par l'ouverture 5de cette coque se situe au dessus du plan de joint J après mise en place de l'électronique dans la coque supérieure, on coule, dans la coque inférieure 3 une résine 6 à l'état liquide en une quantité telle qu'après assemblage des coques le niveau de la résine se situe au dessus du plan de joint mais sans atteindre le volume de sécurité 7,
on assemble les coques et
on attend la prise de la résine.

On aura compris que le plan de joint choisit pour référence est la base de la coque supérieure mais que ce plan de joint n'a pas de contact physique avec la coque inférieure, l'étanchéité étant obtenu du fait que la base de la coque supérieure est plongée dans la couche de résine et se trouve à distance du fond de la coque inférieure où elle est maintenue pour permettre à la résine de se solidifier.

L'orientation des coques a été définie par le fait que dés lors qu'il faut introduire une résine liquide et que celle-ci ne vienne pas souiller l'électronique, l'orientation verticale des coques est souhaitable. Après solidification, le boitier peut être utilisé tête en bas.

Comme cela a été indiqué, on détermine la longueur d'emboitement en sorte que la base de la coque supérieure se positionne à distance de la face interne du fond de la coque inférieure et on dimensionne la section de la coque inférieure pour ménager un espace autour de la base de la coque supérieure qui sera partiellement rempli par la résine.

La quantité de résine évite de noyer le circuit et donc permet de le dépanner. On remplace uniquement le boitier.

Il est à noter qu'il n'est pas nécessaire de faire fabriquer un joint spécifique, la résine s'adaptant à la géométrie du boitier.

La création d'un espace annulaire 10 autour de la coque externe améliore l'étanchéité et en plus permet de verrouiller les coques.On voit que la résine est en contact avec la face interne et la face externe du bas de la coque supérieure et donc agit sur deux faces.

On notera la présence d'un puits 30 permettant d'introduire une clef magnétique qui se positionne à proximité de l'électronique pour agir sur celle-ci.

Ce puits permet d'accéder à proximité d'un composant de l'électronique qui est éloignée de la paroi du boitier.

## Revendications

1. Dispositif comprenant un boitier 1 logeant une électronique obtenu par assemblage de deux coques (2,3) supérieure et inférieure par emboitement en référence à un plan dit de joint (J) horizontal correspondant au plan passant par le bord inférieur de la coque supérieure (2) avec :
- l'une (2) des coques dit coque supérieure ayant des dimensions aptes à loger toute l'électronique que doit contenir le boitier ceci dans un espace dit de sécurité situé à distance du plan de joint J prédéfini,
- l'autre coque dite inférieure ayant des dimensions aptes à loger la base de la coque supérieure plongeant dans de la résine, le niveau de la résine se situant au dessus du plan de joint mais sans atteindre le volume de sécurité (7), ce dispositif étant **caractérisé en ce qu'**il comprend des moyens (11) pour maintenir le bord inférieur de la coque supérieure à distance du fond de la coque inférieure pour noyer les deux faces et le champs inférieur de la coque supérieure lesdits moyens 11 comprenant une jupe (11A) extérieure à la coque supérieure dont le bord libre (11B) forme une butée venant en appui sur le bord libre (3A) de la paroi latérale de la coque inférieure pour en limiter l'emboitement.

2. Dispositif selon la revendication 1 **caractérisé en ce que** la face interne de la coque inférieure est à distance de la face externe de la coque supérieure pour libérer un espace annulaire qui sera rempli par de la résine.

3. Dispositif selon la revendication 2 **caractérisés en ce que** la coque inferieure présente au moins deux pattes (12A) dont les faces externes viennent localement en appui sur la face interne de la coque supérieure pour la maintenir centrée et sans contact avec la paroi latérale de la coque inférieure afin de dégager du volume pour la résine.

4. Dispositif selon la revendication 1 **caractérisé en ce que** la coque supérieure présente des glissières pour y positionner une carte portant l'électronique et la coque inférieure présente une butée pour verrouiller la carte.

5. Dispositif selon la revendication 1 **caractérisé en ce que** pour le passage d'une liaison filaire 40 de l'électronique avec l'extérieur, un trou est localisé dans la paroi inférieure dans l'espace qui sera noyé dans la résine.

## Patentansprüche

1. Vorrichtung umfassend ein Gehäuse 1, das eine elektronische Einheit unterbringt, wobei zwei Hüllen (2, 3), eine obere und eine untere, zusammengebaut sind und im Hinblick auf eine sogenannte waagerechte Trennebene (J) verschachtelt sind, die der sich durch den unteren Rand der oberen Hülle (2) erstreckenden Ebene entspricht, wobei:
- die eine (2) der Hüllen, die sogenannte obere Hülle, Abmessungen zur Unterbringung der ganzen elektronischen Einheit aufweist, die das Gehäuse umfassen soll, und zwar in einem von der vorbestimmten Trennebene (J) entfernten, sogenannten Sicherheitsraum,
- die andere, sogenannte untere Hülle, Abmessungen zur Unterbringung der Basis der oberen, in Harz tauchenden Hülle aufweist, wobei das Harzniveau über der Trennebene liegt, aber das Sicherheitsvolumen (7) nicht erreicht, wobei diese Vorrichtung **dadurch gekennzeichnet ist, dass** sie Mittel (11) umfasst, um den unteren Rand der oberen Hülle vom Boden der unteren Hülle entfernt zu halten, um die beiden Seiten und die untere Schmalseite der oberen Hülle zu überfluten, wobei diese Mittel (11) eine außerhalb der oberen Hülle liegende Schürze (HA) umfassen, deren freier Rand (11B) einen Anschlag ausbildet, der auf dem freien Rand (3 A) der Seitenwand der unteren Hülle zum Abstützen kommt, um ihre Verschachtelung zu begrenzen.

2. Vorrichtung nach Anspruch 1, **dadurch gekennzeichnet, dass** die Innenseite der unteren Hülle von der Außenseite der oberen Hülle entfernt liegt, um einen Ringspalt frei zu lassen, der mit Harz gefüllt sein wird.

3. Vorrichtung nach Anspruch 2, **dadurch gekennzeichnet, dass** die untere Hülle wenigstens zwei Laschen (12A) aufweist, deren Außenseiten auf der Innenseite der oberen Hülle örtlich zum Abstützen kommen, um sie zentriert und ohne Kontakt mit der Seitenwand der unteren Hülle zu halten, um Volumen für Harz freizugeben.

4. Vorrichtung nach Anspruch 1, **dadurch gekennzeichnet, dass** die obere Hülle Gleitschienen aufweist, um darin eine die elektronische Einheit tragende Karte zu positionieren, und die untere Hülle einen Anschlag aufweist, um die Karte zu verriegeln.

5. Vorrichtung nach Anspruch 1, **dadurch gekennzeichnet, dass** zum Hindurchführen einer Drahtverbindung (40) der elektronischen Einheit nach außerhalb ein Loch in der unteren Wand in dem Raum örtlich begrenzt ist, der von Harz überflutet sein wird.

## Claims

1. Device comprising a case 1 housing electronics, obtained by the assembly of two shells (2, 3), upper and lower, by fitting together with reference to a so-called horizontal mating surface (J) corresponding to the plane surface passing along the lower edge of the upper shell (2) with:
- one (2) of the shells, the so-called upper shell, having dimensions capable of housing all the electronics that the case should contain, this in a so-called safety space situated at a distance from the pre-defined mating surface J,
- the other, the so-called lower shell, having dimensions capable of housing the base of the upper shell plunging into the resin, the level of the resin being situated above the mating surface but without attaining the safety volume (7), this device being **characterised in that** it comprises means (11) for keeping the lower edge of the upper shell at a distance from the bottom of the lower shell to immerse the two faces and the lower field of the upper shell, said means 11 comprising a skirt (11A) outside the upper shell, the free edge of which (11B) forms an abutment providing support on the free edge (3A) of the lateral wall of the lower shell to limit the fitting together.

2. Device according to claim 1, **characterised in that** the internal face of the lower shell is at a distance from the external face of the upper shell to free an annular space which will be filled by the resin.

3. Device according to claim 2, **characterised in that** the lower shell has at least two tabs (12A), the external faces of which locally provide support on the internal face of the upper shell to keep it centred and without contact with the lateral wall of the lower shell in order to release the volume for the resin.

4. Device according to claim 1, **characterised in that** the upper shell has slides to position there a board containing the electronics and the lower shell has an abutment for locking the board.

5. Device according to claim 1, **characterised in that** a hole for passing a wire 40 linking the electronics with the outside is located in the lower wall in the space that will be immersed in the resin.
